Europäisches Patentamt

European Patent Office

Office européen des brevets

(19)

(11) **EP 0 673 512 B1**

(12) **EUROPÄISCHE PATENTSCHRIFT**

(45) Veröffentlichungstag und Bekanntmachung des Hinweises auf die Patenterteilung:
**12.02.1997 Patentblatt 1997/07**

(21) Anmeldenummer: **94900120.0**

(22) Anmeldetag: **09.11.1993**

(51) Int Cl.6: **G01R 31/36**, G01R 13/40

(86) Internationale Anmeldenummer:
**PCT/EP93/03135**

(87) Internationale Veröffentlichungsnummer:
**WO 94/14079 (23.06.1994 Gazette 1994/14)**

(54) **LADEZUSTANDSANZEIGE**

CHARGE-STATUS INDICATOR

INDICATEUR D'ETAT DE CHARGE

(84) Benannte Vertragsstaaten:
**AT CH DE FR GB IT LI NL**

(30) Priorität: **12.12.1992 DE 4241975**

(43) Veröffentlichungstag der Anmeldung:
**27.09.1995 Patentblatt 1995/39**

(73) Patentinhaber: **Braun Aktiengesellschaft Frankturt am Main (DE)**

(72) Erfinder: **LANG, Gerhard
D-61276 Altweilnau (DE)**

(56) Entgegenhaltungen:
**EP-A- 0 252 309**

- **EDN ELECTRICAL DESIGN NEWS Bd. 35, Nr. 17 , 20. August 1990 , NEWTON, MASSACHUSETTS US Seite 151 HUFFMAN 'MONITOR CIRCUIT CONSERVES BATTERY ENERGY'**
- **ELECTRONIC DESIGN Bd. 28, Nr. 4 , Februar 1980 , HASBROUCK HEIGHTS, NEW JERSEY US Seite 156 RUBINSTEIN 'LOW-BATTERY THRESHOLD DETECTOR...'**
- **RADIO FERNSEHEN ELEKTRONIK Bd. 32, Nr. 5 , Mai 1983 , BERLIN DD Seite 275 MÜLLER 'BATTERIE-UNTERSPANNUNGSANZEIGE...'**
- **ELECTRONICS. DE 1984 A 1985 : ELECTRONICS WEEK Bd. 46, Nr. WR13 , 21. Juni 1973 , NEW YORK US Seite 130 MCGOWAN 'IC TIMER AUTOMATICALLY MONITORS BATTERY VOLTAGE'**

Printed by Jouve, 75001 PARIS (FR)

**Beschreibung**

Die Erfindung betrifft eine Schaltungsanordnung für eine Ladezustandsanzeige einer Primärbatterie oder einer Sekundärbatterie (wiederaufladbarer Akkumulator) in einem elektrischen Gerät, beispielsweise einem batteriebetriebenen Rasierapparat.

Es sind spannungsabhängige Batterieüberwachungseinrichtungen bekannt, die in einer oder mehreren Stufen den Ladezustand der Batterie während des Betriebs des Gerätes erfassen, und permanent oder intermittierend anzeigen und/oder nach dem Ausschalten des Gerätes über einen bestimmten Ladezustand informieren.

Anzeigeeinrichtungen, die den Ladezustand nach dem Ausschalten des Gerätes permanent mehrstufig anzeigen, erfordern einen hohen technischen Aufwand (Mikrocontroller) und sind somit teuer. Anzeigen, die preiswert sind, liegen aber im Stromverbrauch so hoch, daß eine permanente Anzeige nach dem Ausschalten des Gerätes wegen der Batterieentladung nur für kurze Zeit möglich ist.

Aus der Zeitschrift EDN-Electrical Design News, Bd. 35 (1990) August 20, No. 17, Newton, MA, US, Seite 151 ist weiterhin eine Anzeigeeinrichtung bekannt, bei der die Batteriespannung einem Spannungsteiler zugeführt wird und eine in diesem Spannungsteiler abgegriffene Spannung einem Eingang eines Mikrokontrollers zugeführt wird. Diesem Mikrokontroller werden weiterhin Spannungswerte zur Ausbildung eines Komparators mit einer Hysterese zugeführt sowie eine externe Oszillationsfrequenz, mit der ggf. eine Leuchtdiode als Anzeigeeinrichtung betrieben werden soll. Diese Anzeigeeinrichtung wird dann aktiviert, wenn die Batteriespannung auf einen kritischen Wert abgesunken ist. Eine Reduzierung des Energieverbrauches der Anzeigeeinrichtung wird bei diesem Stand der Technik bei absinkender Batteriespannung realisiert, indem die Anzeigeeinrichtung intermittierend mit der externen Oszillationsfrequenz betrieben wird.

Aufgabe der Erfindung ist es, eine Schaltungsanordnung für eine Ladezustandsanzeige zu schaffen, die einen einfachen, preiswerten Aufbau aufweist und einen so geringen Stromverbrauch hat, daß sie auch nach dem Ausschalten des Gerätes fest mit der Batterie verbunden bleiben kann.

Diese Aufgabe wird durch die Merkmale des Anspruchs 1 gelöst.

Besonders vorteilhaft kann eine solche Anordnung bei einer Flüssigkristallanzeige (LCD) als Anzeigeeinrichtung verwendet werden, auf welche ein Symbol aufgedruckt ist, das im passiven Zustand der Anzeigeeinrichtung sichtbar ist und den Benutzer zum Nachladen des Akkumulators (Sekundärbatterie) oder zum Wechseln der Batterie (Primärbatterie) auffordert.

Weitere vorteilhafte Ausgestaltungen sind in den Unteransprüchen und der Beschreibung angegeben.

Die Erfindung wird im folgenden an Hand eines in der Zeichnung dargestellten Ausführungsbeispiels näher erläutert.

Es zeigen:

Fig. 1    ein Ausführungsbeispiel der Erfindung,

Fig. 2    einen beispielsweisen Aufdruck auf einer Flüssigkristallanzeige, der im passiven Zustand sichtbar ist und

Fig. 3    Signalverläufe in der Schaltungsanordnung in Fig. 1.

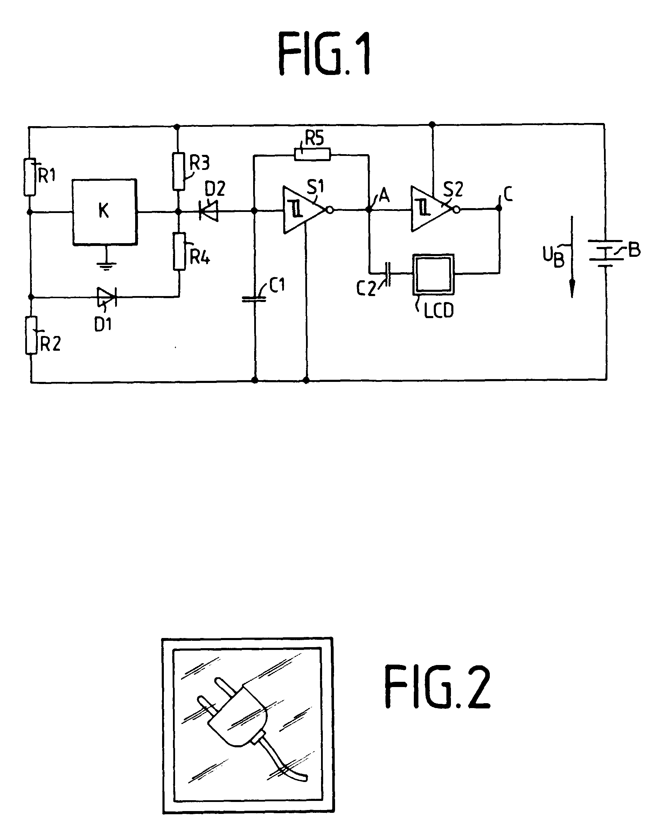

In Fig. 1 ist der Eingang eines Spannungskomperators K an den Teilerpunkt eines aus den beiden Widerständen R1/R2 bestehenden Spannungsteilers, der einer Batterie B parallelgeschaltet ist, geführt. Diese Batterie B ist beispielsweise ein zweizelliger Akkumulator eines elektrischen Rasierapparates. Der Komparator K ist ein handelsüblicher Baustein (Spannungsdetektor) und enthält einen Schmitt-Trigger mit Referenzspannung und einen Ausgangstreiber. Mit dem Spannungsteiler R1/R2 wird die Batteriespannung UB auf einen dem Komparator K angepaßten Wert heruntergeteilt. Der Ausgang des Komparators K ist über einen Widerstand R3 mit dem positiven Pol der Batterie B verbunden, über eine Entkopplungsdiode D2 mit dem Eingang eines Oszillators und über die Serienschaltung eines Widerstands R4 und einer Diode D1 mit dem Eingang des Komparators.

Der Oszillator besteht aus einem Schmitt-Trigger S1 mit invertierendem Ausgang, einem zwischen Ausgang und Eingang des Schmitt-Triggers S1 angeordneten Widerstand R5 und einem zwischen Eingang und Bezugspotential (Minuspol der Batterie B) liegenden Kondensator C1.

Der Ausgang A des Oszillators steht mit dem ersten Anschluß einer Anzeigeeinrichtung, die hier eine Flüssigkristallanzeige LCD (=liquid crystal display) ist, und über einen Schmitt-Trigger S2 mit invertierendem Ausgang mit dem zweiten Anschluß der Anzeigeeinrichtung LCD in Verbindung. Der in Serie zu einem Anschluß der Flüssigkristallanzeige LCD liegende Kondensator C2 dient dazu, die im passiven Zustand des LCD anliegende, unzulässig hohe Gleichspannung zu entkoppeln.

Die Batteriespannung UB eines zweizelligen Akkumulators beträgt im vollgeladenen Zustand ca. 2,7 bis 2,8 Volt. Solange die Batteriespannung UB oberhalb einer ersten Schwellenspannung UB1, beispielsweise 2,5 Volt, liegt, befindet sich die Batterie B in einem Ladezustand "ausreichend Kapazität vorhanden". Wenn die Batteriespannung UB auf eine untere, zweite Schwellenspannung UB2, beispielsweise 2,3 Volt, abgesunken ist, was dem sogenannten "low charge" Punkt entspricht, ist die Batterie bis auf 10 bis 20% ihrer Kapazität entladen. Es ist für den Benutzer besonders vorteilhaft, die Unterschreitung dieses "low charge" Punktes anzuzeigen.

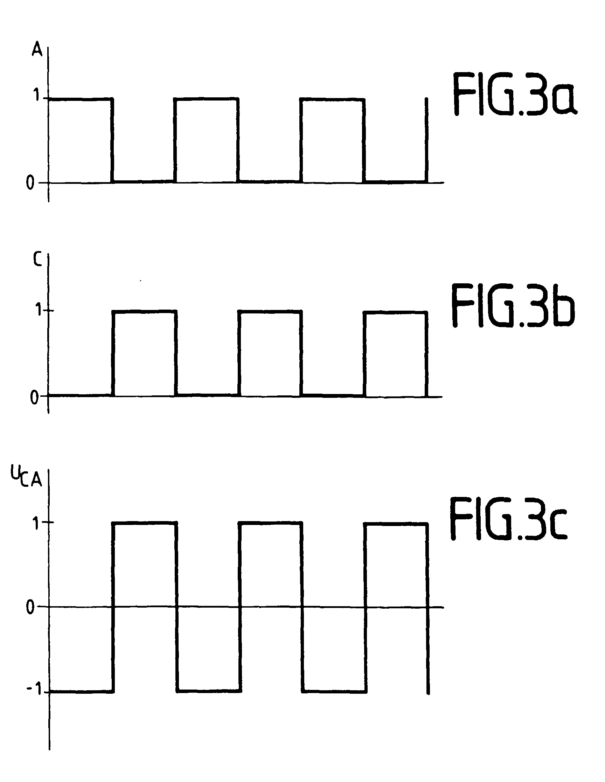

Oberhalb der ersten Schwellenspannung UB1 liegt der Ausgang des Komparators K auf "high" (Pluspotential) und der aus dem Schmitt-Trigger S1, dem Widerstand R5 und dem Kondensator C1 bestehende Oszillator schwingt. An seinem Ausgang A liegt das in Fig. 3a gezeigte Signal, und am Ausgang C des Schmitt-Triggers S2 liegt das in Fig. 3b dargestellte Signal. Die Flüssigkristallanzeige LCD wird damit mit der in Fig. 3c dargestellten Wechselspannung angesteuert und ist aktiviert.

Sinkt nun die Batteriespannung UB unter die zweite Schwellenspannung UB2 (2,3 Volt), kippt der Ausgang des Komparators K von "high" nach "low" (Bezugspotential), der Oszillator wird blockiert und an seinem Ausgang A liegt die Gleichspannung UB. Am Ausgang C des Schmitt-Triggers S2 liegt das Potential O ("low" = Bezugspotential). Ohne den Kondensator C2 läge an der Flüssigkristallanzeige LCD somit die Batteriespannung an, was diese zerstören könnte. Es ist deshalb der Kondensator C2 eingefügt, der die Gleichspannung am LCD über den damit gebildeten kapazitiven Teiler auf ein erlaubtes Maß herabgesetzt. Der Kondensator C2 wird wie folgt bestimmt:

$$C2 = \frac{UB}{ULCD} \cdot CLCD$$

Hierbei ist

C2 = Kapazität des Serienkondensators
UB = Batteriespannung
ULCD = erlaubte statische Gleichspannung am LCD
CLCD = Kapazität der LCD Fläche

Die LCD ist in ihrem passiven Zustand und es wird das in Fig. 2 beispielsweise dargestellte, auf die LCD aufgedruckte Steckersymbol sichtbar, das den Benutzer zum Nachladen oder zum Austausch der Batterie auffordert.

Wird nun die Batterie B aufgeladen, kippt der Komparator K in Folge der mittels des Widerstands R4 und der Diode D1 erzeugten Hysterese erst wieder in seinen anderen Zustand, wenn die Batteriespannung UB die obere, erste Schwellenspannung UB1 (2,5 Volt) erreicht hat. Damit wird sichergestellt, daß die Flüssigkristallanzeige LCD erst wieder in ihren aktiven Zustand versetzt wird - und das in Fig. 2 gezeigte Steckersymbol nicht mehr sichtbar ist - , wenn die Batterie B soweit geladen ist, daß wieder ausreichend Kapazität vorhanden ist.

Durch den sehr geringen Stromverbrauch der Anordnung kann diese in jedem Betriebszustand des Gerätes (auch im ausgeschalteten Zustand) permanent an die Batterie angeschlossen bleiben, so daß der Benutzer immer über den Ladezustand der Batterie informiert ist.

## Patentansprüche

1. Schaltungsanordnung zur Anzeige des Ladezustandes einer Batterie (B) in einem elektrischen Gerät, wobei die Schaltungsanordnung einen die Batteriespannung (UB) erfassenden Spannungskomparator (K) mit Hysterese aufweist, sowie einen von dem Spannungskomparator (K) angesteuerten Oszillator (S1, C1, R5) und eine Anzeigeeinrichtung (LCD), dadurch gekennzeichnet, daß der Oszillator schwingt und die Anzeigeeinrichtung (LCD) in den aktiven Zustand versetzt wird, wenn die von dem Spannungskomparator (K) erfaßte Batteriespannung (UB) oberhalb einer ersten Schwellenspannung liegt, und daß der Oszillator blockiert wird und die Anzeigeeinrichtung (LCD) in den passiven Zustand versetzt wird, wenn die von dem Spannungskomparator (K) erfaßte Batteriespannung (UB) unterhalb einer zweiten Schwellenspannung liegt, wobei der Absolutwert der ersten Schwellenspannung größer ist als der Absolutwert der zweiten Schwellenspannung.

2. Schaltungsanordnung nach Anspruch 1, dadurch gekennzeichnet, daß der Eingang des Spannungskomparators (K) an den Teilerpunkt eines parallel zur Batterie (B) geschalteten Spannungsteilers (R1/R2) geführt ist und daß der Ausgang des Spannungskomparators (K) über einen ersten Widerstand (R3) mit dem einen Pol (+) der Batterie (B) verbunden ist.

3. Schaltungsanordnung nach Anspruch 1, dadurch gekennzeichnet, daß die Hysterese des Spannungskomparators (K) mittels einer von seinem Ausgang auf seinen Eingang rückgekoppelten Serienschaltung aus einem zweiten Widerstand (R4) und einer ersten Diode (D1) erzeugt wird.

4. Schaltungsanordnung nach Anspruch 1, dadurch gekennzeichnet, daß der Oszillator aus einem ersten Schmitt-Trigger (S1) mit invertierendem Ausgang (A), aus einem Rückkopplungwiderstand (R5) zwischen Ausgang und Eingang des Schmitt-Triggers (S1) und aus einem zwischen dem Eingang des Schmitt-Triggers (S1) und dem anderen Pol der Batterie (B), nämlich dem Bezugspotential, liegenden ersten Kondensator (C1) besteht.

5. Schaltungsanordnung nach Anspruch 4, dadurch gekennzeichnet, daß der Ausgang (A) des Oszillators sowohl dem ersten Anschluß der Anzeigeeinrichtung (LCD) als auch über einen zweiten Schmitt-Trigger (S2) mit invertierendem Ausgang (C) dem zweiten Anschluß der Anzeigeeinrichtung (LCD) zugeführt ist.

6. Schaltungsanordnung nach Anspruch 1, dadurch gekennzeichnet, daß der Ausgang des Spannungskomparators (K) und der Eingang des Oszillators über eine zweite Diode (D2) voneinander entkoppelt sind.

7. Schaltungsanordnung nach Anspruch 1, dadurch gekennzeichnet, daß die Anzeigeeinrichtung (LCD) eine Flüssigkristallanzeige ist.

8. Schaltungsanordnung nach Anspruch 7, dadurch gekennzeichnet, daß in Serie zu einem Anschluß der Anzeigeeinrichtung (LCD) ein zweiter Kondensator (C2) geschaltet ist.

9. Schaltungsanordnung nach Anspruch 1 oder 7, dadurch gekennzeichnet, daß auf die Anzeigeeinrichtung (LCD) ein Symbol aufgedruckt ist, das im passiven Zustand der Anzeigeeinrichtung sichtbar ist.

10. Schaltungsanordnung nach Anspruch 1, dadurch gekennzeichnet, daß sie auch nach Ausschalten des Gerätes mit der Batterie verbunden bleibt.

## Claims

1. A circuit arrangement for indicating the charge status of a battery (B) in an electrical appliance, in which the circuit arrangement includes a voltage comparator (K) with hysteresis for detecting the battery voltage (UB), as well as an oscillator (S1, C1, R5) driven by the voltage comparator (K), and an indicating device (LCD), **characterized in that** the oscillator oscillates and the indicating device (LCD) is switched to the active condition when the battery voltage (UB) detected by the voltage comparator (K) is above a first threshold voltage, and that the oscillator is blocked and the indicating device (LCD) is switched to the passive condition when the battery voltage (UB) detected by the voltage comparator (K) is below a second threshold voltage, with the absolute value of the first threshold voltage being greater than the absolute value of the second threshold voltage.

2. The circuit arrangement as claimed in claim 1, **characterized in that** the input of the voltage comparator (K) is applied to the junction of a voltage divider (R1/R2) in parallel arrangement with the battery (B), and that the output of the voltage comparator (K) is connected to the one pole (positive pole) of the battery (B) through a first resistor (R3).

3. The circuit arrangement as claimed in claim 1, **characterized in that** the hysteresis of the voltage comparator (K) is produced by means of a series arrangement formed from a second resistor (R4) and a first diode (D1) fed back from the comparator output to the comparator input.

4. The circuit arrangement as claimed in claim 1, **characterized in that** the oscillator is comprised of a first Schmitt-Trigger (S1) with inverting output (A), a feedback resistor (R5) inserted between output and input of the Schmitt-Trigger (S1), and a first capacitor (C1) connected between the input of the Schmitt-Trigger (S1) and the other pole of the battery (B), that is, reference potential.

5. The circuit arrangement as claimed in claim 4, **characterized in that** the output (A) of the oscillator is applied to both the first terminal of the indicating device (LCD) and, through a second Schmitt-Trigger (S2) with inverting output (C), to the second terminal of the indicating device (LCD).

6. The circuit arrangement as claimed in claim 1, **characterized in that** the output of the voltage comparator (K) and the input of the oscillator are decoupled from each other through a second diode (D2).

7. The circuit arrangement as claimed in claim 1, **characterized in that** the indicating device (LCD) is a liquid crystal display device.

8. The circuit arrangement as claimed in claim 7, **characterized in that** a second capacitor (C2) is connected in series with a terminal of the indicating device (LCD).

9. The circuit arrangement as claimed in claim 1 or claim 7, **characterized in that** a symbol is printed on the indicating device (LCD) which is visible in the passive condition of the indicating device.

10. The circuit arrangement as claimed in claim 1, **characterized in that** its connection to the battery is always maintained also after the appliance is turned off.

## Revendications

1. Circuit en vue de l'affichage de l'état de charge d'une batterie (B) dans un appareil électrique, le circuit présentant un comparateur de tension (K) détectant avec hystérésis la tension de batterie (UB), ainsi qu'un oscillateur (S1, C1, R5) commandé par le comparateur de tension (K) et un dispositif d'affichage (LCD), caractérisé en ce que l'oscillateur oscille et le dispositif d'affichage (LCD) est porté dans l'état actif, lorsque la tension de batterie (UB) détectée par le comparateur de tension (K) se trouve au-dessus d'une première tension de seuil, et en ce que l'oscillateur est bloqué et le dispositif d'affichage (LCD) est porté dans l'état passif, lorsque la tension de batterie (UB) détecté par le comparateur de tension (K) se trouve au-dessous d'une seconde tension de seuil, la valeur absolue de la première tension de seuil étant supérieure à la valeur absolue de la seconde tension de seuil.

2. Circuit selon la revendication 1, caractérisé en ce que l'entrée du comparateur de tension (K) est appliquée au point de division d'un diviseur de tension (R1/R2) monté en parallèle sur la batterie (B) et en ce que la sortie du comparateur de tension (K) est reliée par l'intermédiaire d'une première résistance (R3) avec le pôle (+) de la batterie (B).

3. Circuit selon la revendication 1, caractérisé en ce que l'hystérésis du comparateur de tension (K) est créé au moyen d'un montage série d'une seconde résistance (R4) et d'une première diode (D1) monté à réaction de sa sortie à son entrée.

4. Circuit selon la revendication 4, caractérisé en ce que l'oscillateur se compose d'une première bascule de Schmitt (S1) avec sortie avec inversion (A), d'une résistance de rétroaction (R5) entre sortie et entrée de la bascule de Schmitt (S1) et d'un premier condensateur (C1) se trouvant entre l'entrée de la bascule de Schmitt (S1) et l'autre pôle de la batterie (B), c'est-à-dire le potentiel de référence.

5. Circuit selon la revendication 4, caractérisé en ce que la sortie (A) de l'oscillateur est appliquée non seulement à la première borne du dispositif indicateur (LCD), mais également à la seconde borne du dispositif indicateur (LCD) par l'intermédiaire d'une seconde bascule de Schmitt (S2) avec sortie avec inversion (C).

6. Circuit selon la revendication 1, caractérisé en ce que la sortie du comparateur de tension (K) et l'entrée de l'oscillateur sont découplées l'une de l'autre par une deuxième diode (D2).

7. Circuit selon la revendication 1, caractérisé en ce que le dispositif d'affichage (LCD) est un affichage à cristaux liquides.

8. Circuit selon la revendication 7, caractérisé en ce qu'un deuxième condensateur (C2) est monté en série avec une borne du dispositif d'affichage (LCD).

9. Circuit selon la revendication 1 ou 7, caractérisé en ce que, sur le dispositif d'affichage (LCD), est imprimé un symbole qui est visible dans l'état passif du dispositif d'affichage.

10. Circuit selon la revendication 1, caractérisé en ce qu'il demeure relié à la batterie également après ar-

rêt de l'appareil.

# FIG.1

# FIG.2

FIG.3a

FIG.3b

FIG.3c